# EUROPÄISCHE PATENTSCHRIFT

(11) **EP 0 508 002 B1**
(45) Veröffentlichungstag und Bekanntmachung des Hinweises auf die Patenterteilung: **08.02.1995**
(21) Anmeldenummer: 91303067.2
(22) Anmeldetag: 08.04.1991
(51) Int. Cl.: H05K 5/04

(54) **Kassette zum Einbau in einen Baugruppenträger**
Casing to be built into a component rack
Casette à monter dans une boîte pour des cartes élèctroniques

(43) Veröffentlichungstag der Anmeldung: 14.10.1992
(73) Patentinhaber: Rittal-Werk Rudolf Loh GmbH & Co. KG, 35745 Herborn (DE)
(72) Erfinder: Fursier, Roger, Saltash, Cornwall (GB); Keens, Gary, Roborough, Plymouth (GB)
(74) Vertreter: Jeck, Anton, Dipl.-Ing.

(56) Entgegenhaltungen:
- DE-A- 2 732 139
- DE-A- 3 503 813
- DE-U- 8 711 521
- GB-A- 2 044 545

## Beschreibung

Die Erfindung betrifft eine Kassette zum Einbau in einen Baugruppenträger mit Führungsschienen für einschiebbare Leiterplatten, die aus vier identischen Eckprofilabschnitten, einer Frontplatte und einer Rückwand zusammengestzt ist, wobei die Eckprofilabschnitte an beiden Enden jeweils zusammen mit der Frontplatte oder der Rückwand verbunden sind und wobei die Eckprofilabschnitte einen auf eine Aufnahmenut der Führungsschienen im Baugruppenträger abgestimmten Führungssteg aufweisen.

Bei einer derartigen Kassette, wie sie beispielsweise in dem Schroff-Katalog 1990: "19" - Aufbausysteme und Powersupplies für die Elektronik", 1990, Seiten 42.02, 42.03, 42.06 und 42.07 als bekannt ausgewiesen ist, sind die Eckprofilabschnitte stirnseitig mit der Frontplatte und der Rückwand verschraubt. Bei diesem Montageschritt ist nicht immer sichergestellt, daß die Führungsstege stets so ausgerichtet sind, daß sie ohne weiteres in die dafür vorgesehenen Aufnahmenuten im Baugruppenträger eingeschoben werden können. Oft kann es zu einem Verkanten kommen, was die Einschubbewegung beeinträchtigt.

Es ist Aufgabe der Erfindung, bei einer Kassette der eingangs erwähnten Art den Zusammenbau der Kassette zu erleichtern und dabei eine eindeutige Position und Ausrichtung der Führungsstege zu erreichen.

Die Aufgabe der Erfindung wird dadurch gelöst, daß die Eckprofilabschnitte im wesentlichen L-förmig aus einem horizontalen und einem vertikalen Seitenschenkel gebildet sind, daß in den vertikalen Seitenschenkel eine durchgehende Fixiernut eingebracht ist, in die an vertikalen Abschlußstücken angeformte Fixierlappen einführbar sind, daß an beiden Enden der Abschlußstücke vertikal und horizontal ausgerichtete Befestigungslaschen angeformt sind, daß die Eckprofilabschnitte, die Abschlußstücke und die Frontplatte bzw. die Rückwand miteinander verbindbar sind, und daß wahlweise Seitenplatten, eine Bodenplatte und eine Deckplatte an den Befestigungslaschen anschraubbar sind.

Die Fixierlappen ergeben zusammen mit den Befestigungslaschen Aufnahmen, die an den Abschlußstücken die eingeschobenen Eckprofilabschnitte unverdrehbar aufnehmen und festhalten, so daß die Führungsstege in Position und Ausrichtung festgelegt sind. An den horizontalen und vertikalen Befestigungslaschen sind die Seitenplatten bzw. die Boden- oder die Deckelplatte einfach von außen anschraubbar.

Nach einer Ausgestaltung ist vorgesehen, daß die Abschlußstücke die zwei Eckprofilabschnitte einer vertikalen Seite miteinander verbinden.

Die Anpassung der Kassette an einen vorgegebenen Baugruppenträger geschieht nach einer Ausgestaltung einfach dadurch, daß die Breite der Frontplatte und der Rückwand und die Anordnung ihrer Befestigungsbohrungen so gewählt sind, daß der horizontale Abstand der Führungsstege an der Unterseite und der Oberseite der Kassette ein ganzzahliges Vielfaches einer in dem Baugruppenträger vorgegebenen Teilung für die Festlegung von Führungsschienen beträgt.

Nach einer Ausgestaltung ist vorgesehen, daß die Führungsstege der Eckprofilabschnitte auf der Außenseite im Eckbereich ihrer horizontal ausgerichteten Seitenschenkel angeordnet sind und daß die horizontalen Seitenschenkel nach innen anschließend eine mittels Abschlußstege begrenzte Auflage für die Bodenplatte oder die Deckplatte bilden. Die Kassette kann dann wie eine Leiterplatte in den Baugruppenträger eingesetzt werden. Es sind nur zwei Paare von aufeinander ausgerichteten Führungsschienen im Baugruppenträger erforderlich.

Ist nach einer weiteren Ausgestaltung vorgesehen, daß die horizontalen Befestigungslaschen an den Abschlußstücken so angeformt sind, daß sie mit ihrer Außenseite bündig an die Auflage der Eckprofilabschnitte anschließen und daß die vertikalen Befestigungslaschen an den Abschlußstücken so angeformt sind, daß ihre Außenseiten bündig an die Außenseiten der vertikal ausgerichteten Seitenschenkel der Eckprofilabschnitte anschließen, dann ergeben sich für die Seitenplatten, die Bodenplatten und die Deckplatte an den Eckprofilabschnitten und den Abschlußstücken jeweils in einer Ebene liegende Anschlußflächen.

Um die Verbindung der Eckprofilabschnitte mit den Abschlußstücken sowie der Frontplatte sowie die Rückwand zu erreichen, ist nach einer Ausgestaltung vorgesehen, daß die Stirnseiten der Eckprofilabschnitte mit Gewindeaufnahmen versehen sind, daß die Abschlußstücke, die Frontplatte und die Rückwand darauf ausgerichtete Befestigungsbohrungen tragen und daß die Breite der Frontplatte und der Rückwand die Breite der Kassette festlegen.

Ist nach einer weiteren Ausgestaltung vorgesehen, daß die horizontalen Seitenschenkel der Eckprofilabschnitte auf ihren Innenseiten als Führungsschienen zur Aufnahme einer Leiterplatte ausgebildet sind, dann können in die Kassette zwei Leiterplatten eingeschoben werden. Ist dabei eine Leiterplatte mit einem Steckverbinder versehen, dann ist vorgesehen, daß die Rückwand in einem an eine vertikale Seite der Kassette anschließenden Bereich in Verlängerung der Führungsschienen der zugeordneten Eckprofilabschnitte mit einer Aussparung zum Durchführen eines Steckverbinders versehen ist. Dabei können einheitliche Leiterplatten zum Einschieben in den Baugruppenträger und zum direkten Einschieben in die Kassette verwendet werden, wenn vorgesehen ist, daß der Führungssteg und die Führungsschiene der Eckprofilabschnitte jeweils in einer gemeinsamen horizontalen Ebene angeordnet sind.

Einfache, leicht montierbare Teile ergibt eine Ausgestaltung dann, wenn vorgesehen ist, daß die Eckprofilabschnitte von einem Metall-Extruderprofil abgelängt sind, daß die Abschlußstücke als Metall-Spritzgußteile hergstellt sind und daß die Frontplatte die Seitenplatten, die Bodenplatte und die Deckplatte als Blech-Stanzteile hergestellt sind. Die Rückwand wird als Stanz-Biegeteil aus Blech hergestellt, da diese mit abgewinkelten Flanschen zwischen die horizontalen Befestigungslaschen der zugekehrten Abschlußstücke eingeführt wird.

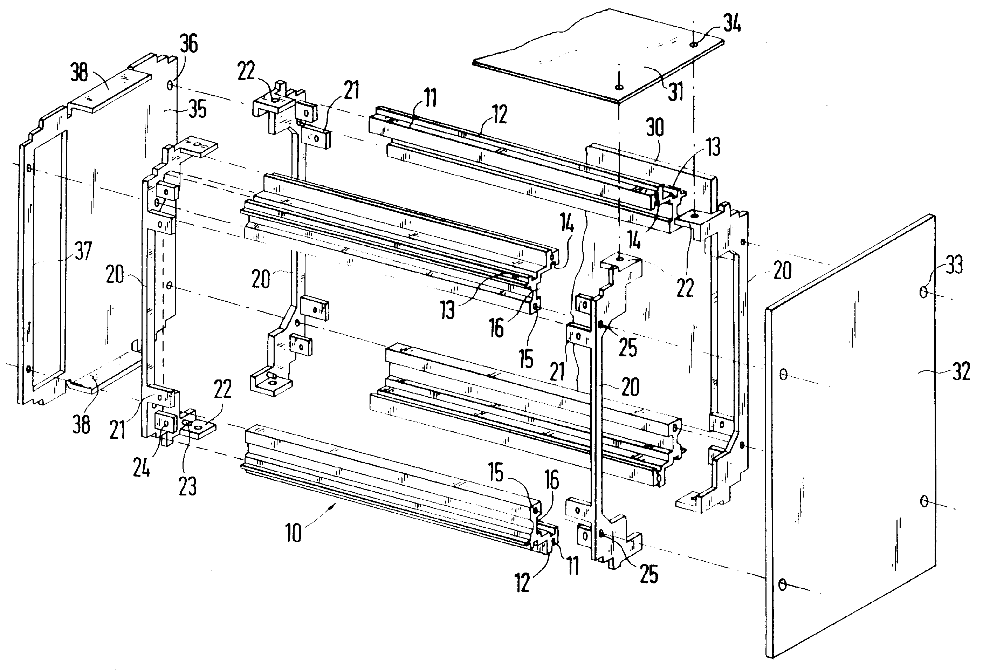

Die Erfindung wird anhand eines in der Zeichnung in Explosionsdarstellung dargestellten Ausführungsbeispiels näher erläutert.

Eine offene Kassette wird nach der Erfindung aus vier identischen Eckprofilabschnitten 10, vier identischen Abschlußstücken 20, einer Frontplatte 32 und einer Rückwand 35 zusammengesetzt. Die Eckprofilabschnitte 10 haben einen im wesentlichen L-förmigen Querschnitt mit einem horizontalen und einem vertikalen Seitenschenkel. Die Eckprofilabschnitte sind so angeordnet, daß ihre horizontalen Seitenschenkel an der Unterseite und der Oberseite der Kassette gegeneinander gerichtet sind. Dies kann durch entsprechende Verdrehung der Eckprofilabschnitte 10 erreicht werden, die vorzugsweise aus einem Extruderprofil abgelängt werden. Daher ist die Tiefe der Kassette leicht anpaßbar. In den nach außen gekehrten Eckbereichen tragen die Eckprofilabschnitte 10 einen vertikal ausgerichteten Führungssteg 13, der an eine Aufnahmenut einer im Baugruppenträger festgelegten Führungsschiene angepaßt ist. Auf der Außenseite der horizontalen Seitenschenkel bilden die Eckprofilabschnitte 10 eine mittels eines Abschlußsteges 12 begrenzte Auflage 11 für eine Deckplatte 31 oder eine identisch ausgebildete Bodenplatte. Auf der Innenseite des vertikalen Seitenschenkels ist eine durchgehende Fixiernut 16 vorgesehen und auf der Innenseite des horizontalen Seitenschenkels ist eine Führungsschiene 14 ausgeformt, die in derselben horizontalen Ebene wie der Führungssteg 13 angeordnet ist. In die Stirnseiten der Eckprofilabschnitte 10 sind Gewindeaufnahmen 15 eingebracht.

Die beiden vertikal übereinander angeordneten Eckprofilabschnitte 10 einer Seite werden an beiden Enden jeweils mit einem Abschlußstück 20 abgeschlossen. Diese Abschlußstücke 20 werden zusammen mit der Frontplatte 32 oder der Rückwand 35 mit den Eckprofilabschnitten 10 verschraubt. Dazu sind Befestigungsbohrungen 33 und 36 der Frontplatte 32 und der Rückwand 35 sowie Befestigungsbohrungen 25 der Abschlußstücke 20 auf die Gewindeaufnahmen 15 der Eckprofilabschnitte 10 ausgerichtet.

An den den Eckprofilabschnitten 10 zugekehrten Seiten tragen die Abschlußstücke 20 unten und oben einen Fixierlappen 24, der in die Fixiernuten 16 der beiden Eckprofilabschnitte 10 eingeführt werden. Außerdem sind an den Enden der Abschlußstücke 20 vertikal und horizontal ausgerichtete Befestigungslaschen 21 und 22 angeformt, die jeweils mit einer Gewindebohrung versehen sind. Diese Befestigungslaschen 21 und 22 sind im Bezug auf die Fixierlappen 24 so angeformt, daß sie mit diesem jeweils eine Aufnahme bilden, in die in vorgegebener Position ein Eckprofilabschnitt 10 eingeschoben und unverdrehbar gehalten werden kann. Die horizontalen Befestigungslaschen 22 schließen mit ihren Außenseiten bündig mit den Auflagen 11 der zugekehrten horizontalen Seitenschenkel der Eckprofilabschnitte 10 ab, während die vertikalen Befestigungslaschen 21 sich bündig an die vertikalen Seitenschenkel der zugeordneten Eckprofilabschnitte 10 anschließen. Diese Fixierung der Eckprofilabschnite 10 in den aus Fixierlappen 24 und den Befestigungslaschen 21 und 22 gebildeten Aufnahmen erleichtert die Montage der Kassette.

Die Breite der Frontplatte 32 und der Rückwand 35 ist so gewählt, daß die Führungsstege 13 an der Unterseite und der Oberseite der zusammengesetzten Kassette einen Abstand aufweisen, der einem ganzzahligen Vielfachen einer Teilung entspricht, die durch die für die Befestigung von Führungsschienen im Baugruppenträger vorgegebene Teilung bestimmt ist.

Da die Führungsschienen 14 der Eckprofilabschnitte 10 in derselben Ebene angeordnet sind wie die Führungsstege 13, können in die Kassette zwei Leiterplatten eingeschoben werden, die dieselbe Abmessung aufweisen wie die direkt in dem Baugruppenträger untergebrachten Leiterplatten. Die Abschlußstücke 20, die Frontplatte 32 und die Rückwand 35 sind zudem so ausgelegt, daß der vertikale Abstand der Führungsstege 13 an die Bauhöhe des Baugruppenträgers angepaßt ist, so daß die Kassette wie eine Leiterplatte in den Baugruppenträger eingesetzt werden kann. Dazu sind dann nur zwei Paare von aufeinander ausgerichteten Führungsschienen im entsprechenden horizontalen Abstand im Baugruppenträger erforderlich. Die Rückwand 35 hat im Anschluß an eine vertikale Seite in Verlängerung der Führungsschienen 14 der horizontalen Seitenschenkel der Eckprofilabschnitte 10 eine Aussparung 37, durch die ein an der Leiterplatte angebrachter Steckverbinder durchgeführt werden kann. Dieser Steckverbinder kann dann beim Einsetzen der Kassette direkt mit einem im Baugruppenträger befestigten, komplementären Steckverbinder verbunden werden. Die Rückwand 35 hat an den horizontalen Kanten abgewinkelte Flansche 38, die zwischen die horizontalen Befestigungslaschen 22 der zugekehrten Abschlußstücke 20 einführbar sind.

Die offene Kassette kann zu einer vollkommen abgeschirmten Kassette vervollständigt werden. Dazu werden die vertikalen Seiten der offenen Kassette mittels Seitenplatten 30 verschlossen, die mit entsprechenden Befestigungsbohrungen versehen sind und mit den vier vertikalen Befestigungslaschen 21 der dieser Seite zugekehrten Abschlußstücke 20 verschraubt werden. In gleicher Weise werden die offene Unterseite und die offene Oberseite mit einer Bodenplatte und einer Deckplatte 31 verschlossen, die beide identisch ausgebildet sind und Befestigungsbohrungen 34 tragen, die auf die Gewindeaufnahmen der zugekehrten vier horizontalen Befestigungslaschen 22 ausgerichtet sind. Die Abschlußstege 12 der Eckprofilabschnitte 10 bilden dabei seitliche Anschläge und eine Art Aufnahme, die das Anbringen der Bodenplatte und der Deckplatte 31 erleichert. Die Führungsstege 13 bleiben dabei frei, so daß auch die vollkommen abgeschirmte Kassette nach wie vor wie eine Leiterplatte in den Baugruppenträger eingesetzt werden kann.

## Patentansprüche

1. Kassette zum Einbau in einen Baugruppenträger mit Führungsschienen für einschiebbare Leiterplatten, die aus vier identischen Eckprofilabschnitten (10), einer Frontplatte (32) und einer Rückwand (35) zusammengestzt ist, wobei die Eckprofilabschnitte (10) an beiden Enden jeweils zusammen mit der Frontplatte (32) oder der Rückwand (35) verbunden sind und wobei die Eckprofilabschnitte (10) einen auf eine Aufnahmenut der Führungsschienen im Baugruppenträger abgestimmten Führungssteg (13) aufweisen,
dadurch gekennzeichnet,
daß die Eckprofilabschnitte (10) im wesentlichen L-förmig aus einem horizontalen und einem vertikalen Seitenschenkel gebildet sind,
daß in den vertikalen Seitenschenkel eine durchgehende Fixiernut (16) eingebracht ist, in die an vertikalen Abschlußstücken (20) angeformte Fixierlappen (24) einführbar sind,
daß an beiden Enden der Abschlußstücke (20) vertikal und horizontal ausgerichtete Befestigungslaschen (21,22) angeformt sind,
daß die Eckprofilabschnitte (10), die Abschlußstücke (20) und die Frontplatte (32) bzw. die Rückwand (35) miteinander verbindbar sind, und
daß wahlweise Seitenplatten (30), eine Bodenplatte und eine Deckplatte (31) an den Befestigungslaschen (21,22) anschraubbar sind.

2. Kassette nach Anspruch 1,
dadurch gekennzeichnet,
daß die Abschlußstücke (20) die zwei Eckprofilabschnitte (10) einer vertikalen Seite miteinander verbinden.

3. Kassette nach Anspruch 1 oder 2,
dadurch gekennzeichnet,
daß die Führungsstege (13) der Eckprofilabschnitte (10) auf der Außenseite im Eckbereich ihrer horizontal ausgerichteten Seitenschenkel angeordnet sind, und
daß die horizontalen Seitenschenkel nach innen anschließend eine mittels Abschlußstege (12) begrenzte Auflage (11) für die Bodenplatte oder die Deckplatte (31) bilden.

4. Kassette nach Anspruch 3,
dadurch gekennzeichnet,
daß die horizontalen Befestigungslaschen (22) an den Abschlußstücken (20) so angeformt sind, daß sie mit ihrer Außenseite bündig an die Auflage (11) der Eckprofilabschnitte (10) anschließen.

5. Kassette nach einem der Ansprüche 1 bis 4,
dadurch gekennzeichnet,
daß die vertikalen Befestigungslaschen (21) an den Abschlußstücken (20) so angeformt sind, daß ihre Außenseiten bündig an die Außenseiten der vertikal ausgerichteten Seitenschenkel der Eckprofilabschnitte (10) anschließen.

6. Kassette nach einem der Ansprüche 1 bis 5,
dadurch gekennzeichnet,
daß die horizontalen Seitenschenkel der Eckprofilabschnitte (10) auf ihren Innenseiten als Führungsschienen (14) zur Aufnahme einer Leiterplatte ausgebildet sind.

7. Kassette nach einem der Ansprüche 1 bis 6,
dadurch gekennzeichnet,
daß die Stirnseiten der Eckprofilabschnitte (10) mit Gewindeaufnahmen (15) versehen sind,
daß die Abschlußstücke (20), die Frontplatte (32) und die Rückwand (35) darauf ausgerichtete Befestigungsbohrungen (25,33,36) tragen und
daß die Breite der Frontplatte (32) und der Rückwand (35) die Breite der Kassette festlegen.

8. Kassette nach einem der Ansprüche 1 bis 7,
dadurch gekennzeichnet,
daß die Rückwand (35) in einem an eine vertikale Seite der Kassette anschließenden Bereich in Verlängerung der Führungsschienen (14) der zugeordneten Eckprofilabschnitte (10) mit einer Aussparung (37) zum Durchführen eines Steckverbinders versehen ist.

9. Kassette nach einem der Ansprüche 1 bis 8,
dadurch gekennzeichnet,
daß die Breite der Frontplatte (32) und der Rückwand (35) und die Anordnung ihrer Befestigungsbohrungen (33,36) so gewählt sind, daß der horizontale Abstand der Führungsstege (13) an der Unterseite und der Oberseite der Kassette ein ganzzahliges Vielfaches einer in dem Baugruppenträger vorgegebenen Teilung für die Festlegung von Führungsschienen beträgt.

10. Kassette nach einem der Ansprüche 1 bis 9,
dadurch gekennzeichnet,
daß der Führungssteg (13) und die Führungsschiene (14) der Eckprofilabschnitte (10) jeweils in einer gemeinsamen horizontalen Ebene angeordnet sind.

11. Kassette nach einem der Ansprüche 1 bis 8,
dadurch gekennzeichnet,
daß die Eckprofilabschnitte (10) von einem Metall-Extruderprofil abgelängt sind,
daß die Abschlußstücke (20) als Metall-Spritzgußteile hergestellt sind, und
daß die Frontplatte (32), die Seitenplatten (30), die Bodenplatte und die Deckplatte (31) als Blech-Stanzteile hergestellt sind.

12. Kassette nach einem der Ansprüche 1 bis 9,
dadurch gekennzeichnet,
daß die Rückwand (35) als Stanz-Biegeteil aus Blech hergestellt ist.

## Claims

1. Casing to be built into a component rack comprising guide rails for insertable printed-circuit boards, said casing being assembled out of four identical pieces (10) of corner profiles, a front panel (32) and a rear panel (35), said pieces (10) each being connected with the front panel (32) or the rear panel (35) and comprising a guide web (13) fitted on a receiving groove of the guide rails in said rack, **characterized** in that
the pieces (10) are formed sustantally L-shaped out of a horizontal side leg and a vertical side leg,
in the vertical side leg there is a through-passing fixing groove (16) in which protruding fixing parts are insertable, said parts being intergral with vertical end pieces (20),
vertically and horizontally directed protruding fixing parts (21, 22) are integral with both ends of the end pieces (20),
the pieces (10), the end pieces (20) and the front panel (32) resp. rear panel (35) are connectable with each other and
side panels (30), a bottom panel and a roof panel (31) are arranged alternatively to become screwed to the said protruding fixing parts (21, 22).

2. Casing as claimed in claim 1, characterized in that the end pieces (20) connect the two end pieces (10) of a vertical side together.

3. Casing as claimed in claim 1 or 2, characterized in that guide webs (13) of the pieces (10) are arranged at the outside and at the corner area of the horizontally directed side leg of the pieces and that the horizontal side legs form a supporting surface (11) joining the guide webs inwardly, limited by end webs (12) and being provided for the bottom panel or the roof panel (31).

4. Casing as claimed in claim 3, characterized in that the horizontal protruding fixing parts (22) are integral with the end pieces (20) so that the outsides of the said parts joins the supporting surface (11) of the pieces (10) in a flushimg manner.

5. Casing as claimed in any of the claims 1 to 3, characterized in that the vertical protruding fixing parts (21) are integral with the end pieces (20) so that the outsides of the said parts joins the outsides of the vertically directed side legs of the pieces (10) of the corner profiles.

6. Casing as claimed in any of the claims 1 to 5, characterized in that the horizontal side legs of the pieces (10) of the corner profiles are formed at their insides as guide rails (14) to receive a printed-circuit board.

7. Casing as claimed in any of the claims 1 to 6, characterized in that
the end walls of the pieces (10) of the corner profiles are provided with threaded bores (15),
the end pieces (20), the front panel (32) and the rear panel (35) are provided with fixing bores (25, 33, 36) fitted to the threaded bores (15) and
the width of the front panel (32) and the rear panel (35) determines the width of the casing.

8. Casing as claimed in any of the claims 1 to 7, characterized in that the rear panel (35) is provided with an opening (37) for put-through a plug-in connector, said opening being positioned in an area joining a vertical side of the casing and being positioned in elongation of the guide rails (14) of the associated pieces (10) of the corner profiles.

9. Casing as claimed in any of the claims 1 to 8, characterized in that the width of the front panel (32) and the rear panel (35) and the position of their fixing bores (33, 36) are choosen so that the horizontal gap between the guide webs (13) at the bottom and the top of the cassette is an integer multiple of a calibration for the determination of guide rails, which calibration is predetermined in the component rack.

10. Casing as claimed in any of the claims 1 to 9, characterized in that the guide web (13) and the guide rail (14) of the pieces (10) of the corner profiles are arranged each in a common horizontal level.

11. Casing as claimed in any of the claims 1 to 8, characterized in that
the pieces (10) of the corner profiles are cut from an extruded metal profile,
the end pieces (20) are manufactured as metal injection-moulding parts and
the front panel (32), the side panels (30), the bottom panel and the roof panel (31) are manufactured as stamped metal plates.

12. Casing as claimed in any of the claims 1 to 9, characterized in that the rear panel (35) is manufactured as metal plate stamped and bent.

## Revendications

1. Cassette à monter dans une boîte pour des cartes électroniques avec des rails de guidage pour des cartes électroniques coulissantes, cassette composée de quatre tronçons profilés d'angle identiques (10), d'une plaque frontale (32) et d'une paroi arrière (35), les tronçons profilés d'angle (10) étant à chaque extrémité reliés à la plaque frontale (32) ou à la paroi arrière (35), et les tronçons profilés d'angle (10) présentant une nervure de guidage (13) harmonisée avec une rainure de logement des rails de guidage dans la boîte,
caractérisée
en ce que les tronçons de profilé d'angle (10) sont en substance en forme de L et composés d'une aile latérale horizontale et d'une aile latérale verticale,
en ce que dans l'aile latérale verticale est pratiquée une rainure de fixation continue (16), dans laquelle peuvent être introduites des pattes de fixation (24) formées sur des pièces de fermeture verticales (20),
en ce qu'aux deux extrémités des pièces de fermeture (20) sont formées des pattes de fixation (21, 22) orientées verticalement et horizontalement,
en ce que les tronçons de profilé d'angle (10), les pièces de fermeture (20) et la plaque frontale (32) ou la paroi arrière (35) peuvent être reliés les uns aux autres, et
en ce qu'aux pattes de fixation (21, 22) peuvent être fixées par vissage et à volonté des plaques latérales (30), une plaque de base et une plaque de recouvrement (31).

2. Cassette suivant la revendication 1,
caractérisée
en ce que les pièces de fermeture (20) relient l'un à l'autre les deux tronçons de profilé d'angle (10) d'un côté vertical.

3. Cassette suivant la revendication 1 ou la revendication 2,
caractérisée
en ce que les nervures de guidage (13) des tronçons de profilé d'angle (10) sont disposées sur la face extérieure dans la zone d'angle de leurs ailes latérales orientées horizontalement, et
en ce que les ailes latérales horizontales constituent en raccordement intérieur un appui (11) borné par des nervures de clôture (12), appui (11) destiné à la plaque de base ou la plaque de recouvrement (31).

4. Cassette suivant la revendication 3,
caractérisée
en ce que les pattes de fixation horizontales (22) sont formées sur les pièces de fermeture (20) de manière telle que leur face extérieure est au ras de l'appui (11) des tronçons de profilé d'angle (10).

5. Cassette suivant l'une quelconque des revendications de 1 à 4,
caractérisée
en ce que les pattes de fixation verticales (21) sont formées sur les pièces de fermeture (20) de manière telle que leurs faces extérieures sont à ras des faces extérieures des ailes latérales orientées verticalement des tronçons de profilé d'angle (10).

6. Cassette suivant l'une quelconque des revendications de 1 à 5,
caractérisée
en ce que les ailes latérales horizontales des tronçons de profilé d'angle (10) sont à leurs faces intérieures en forme de rails de guidage (14) pour la réception d'une carte électronique.

7. Cassette suivant l'une quelconque des revendications de 1 à 6,
caractérisée
en ce que les faces frontales des tronçons de profilé d'angle (10) présentent des logements filetés (15),
en ce que les pièces de fermeture (20), la plaque frontale (32) et la paroi arrière (35) présentent des forures de fixation (25, 33, 36) en alignement avec les logements filetés et
en ce que la largeur de la plaque frontale (32) et de la paroi arrière (35) déterminent la largeur de la cassette.

8. Cassette suivant l'une quelconque des revendications de 1 à 7,
caractérisée
en ce que dans une région raccordée au côté vertical de la cassette la paroi arrière (35) présente, dans le prolongement des rails de guidage (14) des tronçons de profilé d'angle associés (10), un évidement (37) pour le passage d'un connecteur à fiche.

9. Cassette suivant l'une quelconque des revendications de 1 à 8,
caractérisée
en ce que la largeur de la plaque frontale (32) et de la paroi arrière (35) et la disposition de leurs forures de fixation (33, 36) sont choisies de manière telle que la distance horizontale des nervures de guidage (13) à la face inférieure et à la face supérieure de la cassette correspond à un multiple entier d'un pas de consigne prévu dans le module pour l'assujettissement de rails de guidage.

10. Cassette suivant l'une quelconque des revendications de 1 à 9,
caractérisée
en ce que la nervure de guidage (13) et le rail de guidage (14) des tronçons de profilé d'angle (10) sont disposés dans un plan horizontal commun.

11. Cassette suivant l'une quelconque des revendications de 1 à 8,
caractérisée
en ce que les tronçons de profilé d'angle (10) sont découpés dans un profilé métallique extrudé,
en ce que les pièces de fermeture (20) sont des pièces métalliques moulées par injection, et
en ce que la plaque frontale (32), les plaques latérales (30), la plaque de base et la plaque de recouvrement (31) sont des pièces en tôle cintrées estampées.

12. Cassette suivant l'une quelconque des revendications de 1 à 9,
caractérisée
en ce que la paroi arrière (35) est une pièce en tôle cintrée estampée.
